# EUROPÄISCHE PATENTANMELDUNG

(11) **EP 0 794 564 A2**
(43) Veröffentlichungstag der Anmeldung: **10.09.1997**
(21) Anmeldenummer: 97102193.6
(22) Anmeldetag: 12.02.1997
(51) Int. Cl.: H01L 21/329, H01L 21/304, H01L 21/78

(54) **Verfahren zum Herstellen von diskreten elektronischen Elementen**

(30) Priorität: 09.03.1996 DE 19609229
(71) Anmelder: Deutsche ITT Industries GmbH, 79108 Freiburg (DE)
(72) Erfinder: Igel, Günter, Dipl.-Ing., 79331 Teningen (DE); Stroh, Rüdiger Joachim, Dr., 79098 Freiburg (DE)

(57) **Zusammenfassung**

Die Erfindung betrifft ein Verfahren zum Herstellen von diskreten elektronischen Elementen mit aktiven Strukturen in einem mit einer Epitaxieschicht verstärkten SOI (Silicon 0n Isolator) - Substrat, dessen Oberfläche die Orientierung 〈100〉 aufweist, bei dem in der mit der Epitaxieschicht verstärkten, ersten Siliziumschicht 1 durch anisotropes Ätzen ein Graben 6 mit sich in Richtung der Isolatorschicht 2 verjüngendem Durchmesser erzeugt wird, der sich bis zu der Isolatorschicht 2 erstreckt, an den Seitenwänden 7 des Grabens 6 eine Isolationsschicht ausgebildet wird, ein an den Graben 6 angrenzender Breich der Isolatorschicht 2 entfernt wird, so daß ein Teil der zweiten, durch die Isolatorschicht 2 von der ersten getrennten Siliziumschicht 3 freigelegt wird, die aktive Struktur unterhalb des an den Graben 7 angrenzenden, entfernten bzw. zu entfernenden Bereichs in der zweiten Silziumschicht 3 ausgebildet wird und auf der Isolationsschicht und dem aktiven Element eine Kontaktschicht 10 zum Kontaktieren der aktiven Struktur aufgebracht wird.

## Beschreibung

Die Erfindung betrifft ein Verfahren zum Herstellen von diskreten elektronischen Elementen.

Ein breites Einsatzgebiet von diskreten elektronischen Elementen findet sich in der Halbleitertechnologie. Es werden mit bekannten Halbleitertechnologieverfahren aktive Strukturen auf Halbleiterwafer, insbesondere Siliziumwafer, aufgebracht, die so erzeugten elektronischen Elemente aus dem Halbleiterwafer herausgelöst und geeignet kontaktiert. Als diskrete elektronische Elemente kommen beispielsweise Dioden, insbesondere pn-Dioden und Schottky-Dioden, deren aktive Strukturen entsprechend pn-Übergänge oder Metallhalbleiterübergänge sind, oder Leistungselemente, die mehrere aktive Strukturen aufweisen können, in Betracht. Bei derartigen elektronischen Elementen steigen die Eigenschaften an deren Hochfrequenzeigenschaften immer weiter an. Daher müssen die aktiven Strukturen möglichst klein ausgebildet werden. Dies ist technologisch jedoch ziemlich aufwendig. Die Photolithographieverfahren, die zum Herstellen solcher kleinen aktiven Strukturen erforderlich sind, werden sehr aufwendig, so daß das Herstellungsverfahren und die elektronischen Elemente teuer werden.

Der Erfindung liegt die Aufgabe zugrunde, ein Verfahren zum Herstellen von diskreten elektronischen Elementen zu schaffen, mit dem kleine aktive Strukturen kostengünstig hergestellt werden können.

Diese Aufgabe wird durch ein Verfahren zum Herstellen von diskreten elektronischen Elementen mit aktiven Strukturen in einem mit einer Epitaxieschicht verstärkten SOI (Silicon on Isolator)-Substrat, dessen Oberfläche die Orientierung 〈100〉 aufweist, bei dem in der mit der Epitaxieschicht verstärkten, ersten Siliziumschicht durch anisotropes Ätzen ein Graben mit sich in Richtung der Isolatorschicht verjüngendem Durchmesser erzeugt wird, der sich bis zu der Isolatorschicht erstreckt; an den Seitenflächen des Grabens eine Isolationsschicht ausgebildet wird; ein an den Graben angrenzender Bereich der Isolatorschicht entfernt wird, so daß ein Teil der zweiten, durch die Isolatorschicht von der ersten getrennten Siliziumschicht freigelegt wird; die aktive Struktur unterhalb des an den Graben angrenzenden, entfernten bzw. zu entfernenden Bereichs in der zweiten Siliziumschicht ausgebildet wird und auf der Isolationsschicht und dem aktiven Element eine Kontaktschicht zum Kontaktieren der aktiven Struktur aufgebracht wird, gelöst.

Dieses Verfahren hat den Vorteil, daß aufgrund der Form des in der ersten Siliziumschicht ausgebildeten Grabens in der zweiten Siliziumschicht eine aktive Struktur ausgebildet werden kann, die Kleiner ist als es der Auflösung des verwendeten Photolithographieverfahrens entspricht, da mit dem Photolithographieverfahren nur die Maskierung für die Öffnung des Grabens an der Substratoberfläche erzeugt werden muß. Die Maskierung erfolgt auf der ersten Siliziumschicht, wohingegen das aktive Element in der zweiten Siliziumschicht ausgebildet wird. Der Unterschied in der Auflösung des benötigten Photolithographieverfahrens zu der Größe der aktiven Struktur, die mit dem Photolithographieverfahren noch hergestellt werden kann, ist durch das Verhältnis der Durchmesser an den entgegengesetzen Enden des Grabens bestimmt. Dieses Verhältnis kann durch die Dicke der ersten Isolatorschicht, also insbesondere durch die Dicke der Epitaxieschicht, mit welcher dieser verstärkt ist, variiert werden. Es kann somit eine kleine aktive Struktur mit einem Photolithographieverfahren hergestellt werden, das wesentlich weniger aufwendiger ist, als es üblicherweise zum Herstellen dieser Struktur erforderlich wäre.

Es wird bei diesem Verfahren der Aufbau eines SOI-Substrats genutzt, welches aus zwei Siliziumschichten besteht, die durch eine Isolatorschicht voneinander isoliert sind. Daher haben die in der zweiten Siliziumschicht ausgebildeten aktiven Elemente keinen direkten elektrischen Kontakt zu der ersten Siliziumschicht.

Die Reihenfolge der Verfahrensschritte des Herstellungsverfahrens hängt von den speziellen Herstellungsbedingungen ab. Das Verfahren kann in der obengenannten Reihenfolge durchgeführt werden. Es kann aber auch die Reihenfolge geändert werden. So kann beispielsweise das Ausbilden der Isolationsschicht an den Seitenflächen des Grabens erst erfolgen, nachdem die aktive Struktur ausgebildet worden ist.

Gemäß einer vorteilhaften Weiterbildung der Erfindung ist die Isolatorschicht eine Siliziumnitridschicht. Dies hat den Vorteil, daß sich die Isolatorschicht in verschiedenen Eigenschaften genügend von dem Silizium unterscheidet. Vorteilhafterweise folgt das Ausbilden der Isolationsschicht an den Seitenwänden des Grabens durch Oxidation des Siliziums. In diesem Fall muß keine zusätzliche Isolationsschicht aufgebracht werden. Bei der Verwendung von Siliziumnitrid als Isolatorschicht kann die Oxidation zudem gezielt nur in der ersten Siliziumschicht durchgeführt werden, da die Oxidation von Siliziumnitrid wesentlich langsamer erfolgt als die Oxidation von Silizium, so daß die Siliziumnitridschicht bezüglich der Oxidation passivierend wirkt.

Gemäß einer günstigen Weiterbildung der Erfindung kann die erste Siliziumschicht vollständig oxidiert werden. Dann wird eine elektrische Leitung zwischen der zweiten Siliziumschicht, in der die aktive Struktur ausgebildet ist, und der ersten Siliziumschicht vollständig verhindert. Dadurch werden parasitäre Kapazitäten, die ein möglichst schnelles Schalten der aktiven Struktur verhindert würden, wesentlich verringert.

Gemäß einem vorteilhaften Ausführungsbeispiel der Erfindung umfaßt die zweite Siliziumschicht zwei Schichten, von denen die an die Isolatorschicht angrenzende Schicht eine kleinere Dotierung als die andere Schicht aufweist. Die an die Isolatorschicht angrenzende Schicht kann eine Epitaxieschicht sein. Durch die geringere Dotierung dieser Schicht kann man spezielle Parameter des elektronischen Elements einstellen, die mit dem Substrat nicht erreichbar wären. Hierzu gehören insbesondere Durchbruchspannung und elektrische Kapazität. Die andere Schicht gewährleistet gleichzeitig eine gute elektrische Leitfähigkeit.

Gemäß einem bevorzugten Ausführungsbeispiel der Erfindung wird das aktive Element durch Einbringen eines dotierten Bereichs in die zweite Siliziumschicht erzeugt, welcher von zu dem Dotierungstyp des Substrats entgegengesetztem Dotierungstyp ist. Auf diese Weise wird ein pn-Übergang und somit eine pn-Diode erzeugt. Das Einbringen des aktiven Elements kann in diesem Fall vor Entfernen des Bereiches der Nitridschicht erfolgen.

Gemäß einem weiteren Ausführungsbeispiel der Erfindung kann in dem freigelegten Teil der zweiten Siliziumschicht eine Metallschicht aufgebracht werden. So entsteht ein Metallhalbleiterübergang. Wenn die zweite Siliziumschicht aus zwei Schichten mit unterschiedlichen Dotierung besteht, wird auf diese Weise eine Schottky-Diode erzeugt.

Gemäß einem weiteren Ausführungsbeispiel der Erfindung können in einem Substrat mehrere der Gräben mit aktiven Strukturen ausgebildet werden. Dies ist für alle Bauelemente günstig, bei denen mehrere aktive Strukturen zueinander beabstandet angebracht werden sollen. Beispiele hierfür sind Leistungsbauelemente, bei denen durch Verwenden mehrerer räumlich voneinander getrennter, elektrisch miteinander verbundener Strukturen erreicht wird, daß sich der Stromfluß durch das Substrat aufteilt. Es kann dadurch eine bessere Wärmeverteilung erreicht werden. Ein weiteres Einsatzgebiet von Halbleitern mit mehreren voneinander räumlich getrennten aktiven Strukturen sind beispielsweise DMOS-Transistoren.

Im folgenden wird die Erfindung anhand der Zeichnung näher erläutert. Es zeigen
Fig. 1a bis 1f eine gemäß dem erfindungsgemäßen Verfahren hergestellte Diode mit pn-Übergang,
Fig. 2 eine gemäß dem erfindungsgemäßen Verfahren hergestellte Schottky-Diode und
Fig. 3 einen Ausschnitt aus einer gemäß dem erfindungsgemäßen Verfahren hergestellten Leistungsdiode.

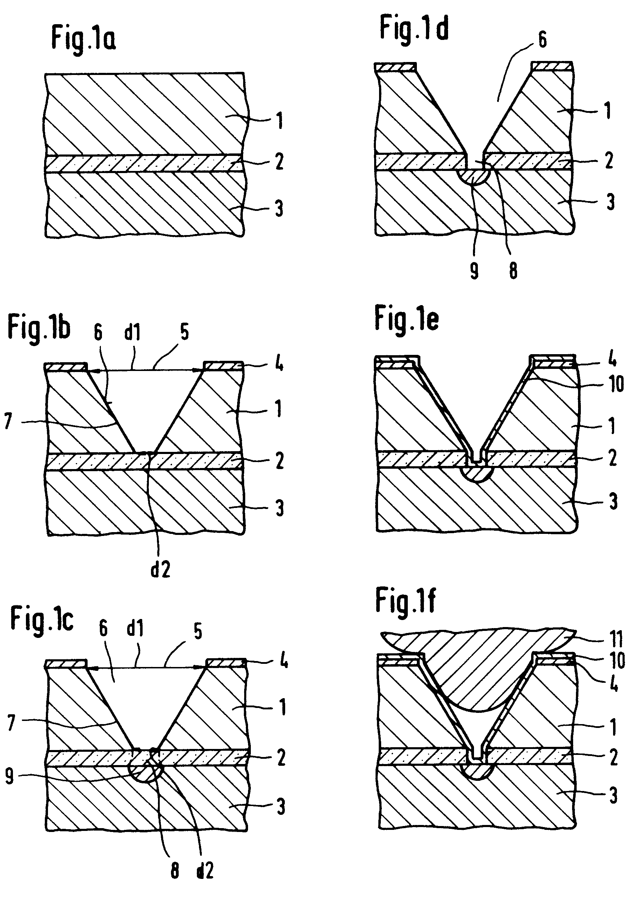

Fig. 1a zeigt ein SOI-Substrat mit einer ersten Siliziumschicht 1, einer Isolatorschicht 2 und einer zweiten Siliziumschicht 3. Die erste Siliziumschicht 1 ist mit einer Epitaxieschicht verstärkt, was in der Zeichnung nicht zu erkennen ist. Durch die Epitaxieschicht wird die gewünschte Dicke der ersten Siliziumschicht erreicht. Die Oberfläche der ersten Siliziumschicht hat die Orientierung 〈100〉.

In Fig. 1b ist auf die erste Siliziumschicht 1 eine Maskierungsschicht 4 mit einer Öffnung 5 einer vorgegebenen Breite bzw. eines vorgegebenen Durchmessers d1 aufgebracht. In die erste Siliziumschicht 1 ist ein kegelstumpfförmiger Graben 6 mit sich in Richtung der Isolatorschicht 2 verjüngendem Durchmesser geätzt worden. Die Neigung seiner Seitenwände 7 ist durch die Orientierung der ersten Siliziumschicht 1 festgelegt. Das Verhältnis des Durchmessers d1 seiner oberen Öffnung zu dem Durchmesser d2 seiner unteren Öffnung wird somit durch die Dicke der ersten Siliziumschicht 1 bestimmt.

In Fig. 1c ist in die zweite Siliziumschicht 3 unterhalb des an den Graben 6 angrenzenden Bereiches 8 ein dotierter Bereich 9 eingebracht worden. Die Dotierung erfolgte in diesem Fall durch die Isolatorschicht 2 hindurch. Der Graben 6 wurde dabei zur Maskierung verwendet. Dabei wird ein dotierter Bereich 9 von etwa der Größe des unteren Durchmessers d2 des Grabens ausgebildet. Zum Erzeugen dieses dotierten Bereichs ist ein Photolithographieverfahren erforderlich, dessen räumliche Auflösung lediglich dazu ausreichen muß, eine Öffnung mit dem oberen Durchmesser d1 des Grabens 6 herzustellen. Der dotierte Bereich 9 ist vom entgegengesetzen Dotierungstyp wie der Dotierungstyp der zweiten Siliziumschicht 3, so daß ein pn-Übergang und damit eine Diode erzeugt wird.

In der Fig. 1d ist aus der Isolatorschicht 2 der an den Graben 6 angrenzende Bereich 3 entfernt. Dies wird üblicherweise durch Ätzen bewirkt. Das Entfernen des Bereiches 8 kann durch anisotropes Ätzen erfolgen. Es ist auch möglich die Reihenfolge der in der Fig. 1c und 1d durchgeführten Schritte zu vertauschen, so daß zuerst der Bereich 8 auf der Isolatorschicht 2 entfernt und dann der dotierte Bereich 9 eingebracht. wird.

In Fig. 1e sind die Seitenwände 8 des Grabens 6, die Seitenwände des aus der Isolatorschicht 2 entfernten Bereiches 8 und der dotierte Bereich 9 mit einer Kontaktschicht 10 überdeckt, welche üblicherweise aus einem Metall besteht. Vor dem Aufbringen der Kontaktschicht 10 ist es erforderlich, daß zumindest an den Seitenwänden 7 des Grabens 6 eine Isolationsschicht ausgebildet wird. In dem gezeigten Ausführungsbeispiel wurde hierzu die erste Siliziumschicht 1 vollständig oxidiert. Dies muß spätenstens nach den bis zur Herstellung des in Fig. 1d gezeigten elektronischen Elementes erfolgen. Die Oxidation kann aber auch bereits nach dem Herstellen des Grabens 6, wie es in Fig. 1b gezeigt ist, erfolgen. Bei der Oxidation der ersten Siliziumschicht 1 wird ausgenutzt, daß die Oxidation von Silizium viel schneller erfolgt als die Oxidation von dem Material der Isolatorschicht 2, welches bevorzugterweise Siliziumnitrid ist. In diesem Fall wirkt das Siliziumnitrid oxidationshemmend, so daß die Oxidation lediglich in der Isolatorschicht 2 erfolgt. Durch die Oxidation der ersten Siliziumschicht 1 wird sichergestellt, daß es keine parasitären Kapazitäten zwischen der ersten Siliziumschicht 1 und der zweiten Siliziumschicht 3 gibt.

In Fig. 1f ist dargestellt, wie die Kontaktschicht 10 mit einem Kontaktanschluß 11 verbunden ist. Der Kontaktanschluß 11 kann durch Bonden erfolgen. Wie man der Fig. 1f entnimmt, sitzt der Kontaktanschluß 11 aufgrund seiner von der Form des Grabens 6 verschiedenen Form nur an den Seitenwänden 7 des Grabens 6 auf der Kontaktschicht 10 auf. Der dotierte Bereich 9 wird aufgrund der Verbindung über die Kontaktschicht 10 trotzdem zuverlässig angeschlossen. Jedoch wird dadurch, daß der Kontaktanschluß 11 nicht direkt auf dem dotierten Bereich 9 aufsitzt, vermieden, daß das elektronische Element infolge der Kontaktierung durch den Bonddruck oder den Druck einer Umhüllung auf den Bondkontakt in seiner Funktion beeinträchtigt oder mechanisch zerstört wird. Der zweite für den pn-Übergang erforderliche Kontaktanschluß erfolgt in herkömmliche Weise über das Substrat, welches hier durch die zweite Siliziumschicht 3 gebildet wird.

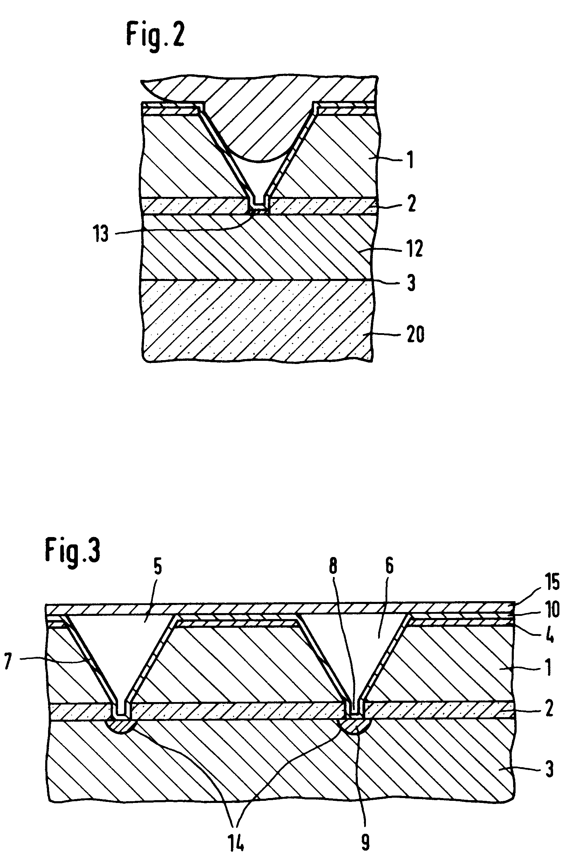

In Fig. 2 ist eine Schottky-Diode gezeigt, welche nach dem erfindungsgemäßen Verfahren hergestellt worden ist. Es wird ebenfalls wie in der Fig. 1 von einem SOI-Substrat ausgegangen, welches eine erste Siliziumschicht 1, eine Isolatorschicht 2 und eine zweite Siliziumschicht 3 aufweist. Die erste Siliziumschicht 1 ist wie bei dem Ausführungsbeispiel der Figur 1 mit einer nicht in der Figur erkennbaren Epitaxieschicht verstärkt, wodurch eine vorgegebene Dicke der ersten Siliziumschicht 1 erreicht wird. In dem Ausführungsbeispiel der Fig. 2 umfaßt die zweite Siliziumsschicht 3 ein Grundsubstrat 20 und eine Epitaxieschicht 12, wobei die Epitaxieschicht 12 eine geringere Dotierung als das Grundsubstrat 20 aufweist. Der Graben 6, der in der Isolatorschicht 2 entfernte Bereich 8, die Kontaktschicht 10 und der Kontaktanschluß 11 werden analog zu dem im Zusammenhang mit der Fig. 1 erläuterten Verfahren hergestellt. Im Unterschied zu Fig. 1 wird anstelle des dotierten Bereichs 9 eine Metallschicht 13 auf die Epitaxieschicht 12 der zweiten Siliziumschicht 3 aufgebracht. Bei diesem Ausführungsbeispiel ist es selbstverständlich erforderlich, zuerst den Bereich 8 in der Isolatorschicht 8 zu entfernen und dann die Metallschicht 13 aufzubringen. Für die übrigen Verfahrensschritte wird auf das Ausführungsbeispiel der Fig. 1 verwiesen.

In Fig. 3 ist ein Ausschnitt aus einer Leistungs-pn-Diode gezeigt. Es sind zwei pn-Übergänge 14 gezeigt, von denen sich weitere entsprechend in beide Richtungen fortsetzen können. Diese pn-Übergänge werden mit dem im Zusammenhang in Fig. 1 beschriebenen Verfahren bis zu der Ausbildung der Fig. 1e entsprechend hergestellt. Es werden dabei mehrere pn-Übergänge nebeneinander erzeugt. Der Abstand der pn-Übergänge 14 kann zuvor festgelegt werden. Der minimale Abstand ist durch die Auflösung des Photolithographieverfahrens, mit dem die Maskierung zur Ausbildung der Gräben 6 erzeugt wird, vorgegeben. Oberhalb dieses minimalen Abstandes kann der Abstand der pn-Übergänge 14 voneinander beliebig variiert werden. Zur Kontaktierung der Kontaktschicht 13 wird eine Metallplatte 15, die die verschiedenen pn-Übergänge von der oberen Seite kontaktiert, aufgebracht. Der zweite Kontakt erfolgt in herkömmlicher Weise über das Substrat, welches hier durch die zweite Siliziumschicht 3 gebildet wird.

## Patentansprüche

1. Verfahren zum Herstellen von diskreten elektronischen Elementen mit aktiven Strukturen in einem mit einer Epitaxieschicht verstärkten SOI (Silicon 0n Isolator) - Substrat, dessen Oberfläche die Orientierung 〈100〉 aufweist, bei dem
- in der mit der Epitaxieschicht verstärkten, ersten Siliziumschicht (1) durch anisotropes Ätzen ein Graben (6) mit sich in Richtung der Isolatorschicht (2) vejüngendem Durchmesser erzeugt wird, der sich bis zu der Isolatorschicht (2) erstreckt,
- an den Seitenwänden (7) des Grabens (6) eine Isolationsschicht ausgebildet wird,
- ein an den Graben (7) angrenzender Bereich der Isolatorschicht (2) entfernt wird, so daß ein Teil der zweiten, durch die Isolatorschicht (2) von der ersten getrennten Siliziumschicht (3) freigelegt wird,
- die aktive Struktur unterhalb des an den Graben (7) angrenzenden, entfernten bzw. zu entfernenden Bereichs in der zweiten Silziumschicht (3) ausgebildet wird und
- auf der Isolationsschicht und dem aktiven Element eine Kontaktschicht (10) zum Kontaktieren der aktiven Struktur aufgebracht wird.

2. Verfahren nach Anspruch 1, dadurch gekennzeichnet, daß die Isolatorschicht (2) eine Siliziumnitridschicht ist.

3. Verfahren nach einem der vorangehenden Ansprüche, dadurch gekennzeichnet, daß das Ausbilden der Isolationsschicht an den Seitenwänden (7) des Grabens (6) durch Oxidation des Siliziums erfolgt.

4. Verfahren nach einem der vorangehenden Ansprüche, dadurch gekennzeichnet, daß die erste Siliziumschicht (1) vollständig oxidiert wird.

5. Verfahren nach einem der vorangehenden Ansprüche, dadurch gekennzeichnet, daß die zweite Siliziumschicht (3) zwei Schichten umfaßt, von denen die an die Isolatorschicht (2) angrenzende Schicht eine kleinere Dotierung als die andere Schicht aufweist.

6. Verfahren nach einem der vorangehenden Ansprüche, dadurch gekennzeichnet, daß daß das aktive Element durch Einbringen eines dotierten Bereichs (9) in die zweite Siliziumschicht (3) erzeugt wird, der von zu dem Dotierungstyp des Substrats entgegengesetzem Dotierungstyp ist.

7. Verfahren nach einem der Ansprüche 1 bis 5, dadurch gekennzeichnet, daß in dem freigelegten Teil der zweiten Siliziumschicht (3) eine Metallschicht (13) aufgebracht wird.

8. Verfahren nach einem der vorangehenden Ansprüche, dadurch gekennzeichnet, daß in einem Substrat mehrere der Gräben (6) mit aktiven Strukturen ausgebildet werden.
